# EUROPÄISCHE PATENTSCHRIFT

(11) **EP 4 264 654 B1**
(45) Veröffentlichungstag und Bekanntmachung des Hinweises auf die Patenterteilung: **18.11.2026**
(21) Anmeldenummer: 21835671.5
(22) Anmeldetag: 09.12.2021
(51) Int. Cl.: H01J 37/32

(54) **VORRICHTUNG ZUR AUSBILDUNG VON AMORPHEN KOHLENSTOFFSCHICHTEN AUF BAUTEIL-OBERFLÄCHEN MIT REDUZIERTER OBERFLÄCHENRAUHEIT**
DEVICE FOR FORMING AMORPHOUS CARBON LAYERS ON COMPONENT SURFACES HAVING REDUCED SURFACE ROUGHNESS
DISPOSITIF DE FORMATION DE COUCHES DE CARBONE AMORPHE SUR DES SURFACES DE COMPOSANTS AYANT UNE RUGOSITÉ DE SURFACE RÉDUITE

(30) Priorität: 15.12.2020 DE 102020215892
(43) Veröffentlichungstag der Anmeldung: 25.10.2023
(73) Patentinhaber: Fraunhofer-Gesellschaft zur Förderung der angewandten Forschung e.V., 80686 München (DE)
(72) Erfinder: HOFMANN, Falko, 01277 Dresden (DE); WEIHNACHT, Volker, 01277 Dresden (DE); KAULFUSS, Frank, 01277 Dresden (DE)
(74) Vertreter: Pfenning, Meinig & Partner mbB
(86) Internationale Anmeldenummer: PCT/EP2021/084919
(87) Internationale Veröffentlichungsnummer: WO 2022/128719

(56) Entgegenhaltungen:
- EP-A1- 1 245 694
- EP-A2- 1 826 810
- WO-A2-2005/038857
- DE-A1- 3 901 401
- US-A1- 2002 007 796
- US-B1- 6 465 793

## Beschreibung

Die Erfindung betrifft eine Vorrichtung zur Ausbildung von amorphen Kohlenstoffschichten auf Bauteiloberflächen mit reduzierter Oberflächenrauheit.

Harte, amorphe Kohlenstoffschichten mit einem hohen Anteil von Diamantbindungen lassen sich sehr effektiv nur mit Vakuum-Lichtbogenplasma-Verfahren abscheiden. Dabei wird mittels einer stromstarken Entladung Graphit aus einem Target in ein Plasma mit energiereichen Teilchen und einem hohen Ionisierungsgrad überführt, das beim Auftreffen auf eine Oberfläche eines zu beschichtenden Bauteils eine harte Kohlenstoffschicht bildet. Ein unvermeidliches Problem beim Vakuum-Lichtbogenverdampfen besteht jedoch darin, dass neben dem Plasma auch größere Partikel (Droplets) aus dem Graphittarget herausgerissen werden, die in der wachsenden Kohlenstoffschicht Wachstumsdefekte verursachen und eine Aufrauhung der Oberfläche nach sich ziehen. Raue Oberflächen an Kohlenstoffschichten führen in der Regel zu einer Verschlechterung der mechanisch-tribologischen Eigenschaften bei der Anwendung als Reibungsminderungs- und Verschleißschutzschicht auf Werkzeugen, Komponenten und Bauteilen bzw. lassen den Einsatz der Beschichtung gar nicht erst zu.

Mit dem bekannten so genannten Laser-Arc-Verfahren steht eine spezielle Variante des Vakuum-Lichtbogenplasma-Verfahrens zur Verfügung. Dabei wird ein lang gestrecktes walzenförmiges Target aus Grafit eingesetzt. Auf diesem rotierenden als Kathode geschalteten Target erfolgt die Zündung einer elektrischen Lichtbogenentladung lokal gezielt mittels eines auf die rotierende Oberfläche eines Targets gerichteten Laserstrahlpulses.

Die elektrische Bogenentladung bricht nach einer vorgebbaren Zeit durch Abschaltung des elektrischen Stromflusses wieder zusammen. Nachfolgend erfolgt eine erneute Zündung eines elektrischen Lichtbogens an einem anderen Ort der Targetoberfläche, der wieder durch Abschalten erlischt. Diese Prozessfolge wird mehrmals wiederholt, so dass ein periodischer Pulsbetrieb erfolgt. So kann ein sehr gleichmäßiger Abtrag von Werkstoff vom Target und eine effektive Beschichtung von Substratoberflächen mit hoher Beschichtungsrate erreicht werden. Mit dem Laser-Arc-Verfahren wurde eine Verringerung des geschilderten Problems mit den Partikeln erreicht. Grundsätzlich besteht das Problem bei diesem Verfahren jedoch weiterhin, so dass sich Wachstumsdefekte infolge von mit dem ionisierten Plasma mitgeführten Droplets nicht ausreichend vermeiden lassen.

Das beschriebene grundsätzliche Problem besteht für alle mittels Vakuum-Lichtbogenverdampfung ausgebildeten Beschichtungen. Die besondere Bedeutung bei Kohlenstoffschichten ist jedoch, dass kein alternatives wirtschaftliches Abscheideverfahren für superharte Kohlenstoffschichten zur Verfügung steht.

Eine momentan eingesetzte Lösung des Problems ist die Glättung der rauen Kohlenstoffschichten nach der Beschichtung, wobei ein mit abrasiven Mikropartikeln, z.B. Diamant oder Siliziumkarbid besetztes Bearbeitungswerkzeug (z.B. Bürste oder Schleifband) eingesetzt werden kann. Alternativ kann auch mit Suspensionen eines abrasiven Schleifmediums und einem an die Konturen der beschichteten Komponenten/des beschichteten Bauteils angepassten Bearbeitungswerkzeuges gearbeitet werden. Weitere Lösungen bestehen in der Verwendung schnell rotierender Drahtbürsten oder einer Selbstglättung der mit Kohlenstoff beschichteten Teile in einem Trommel-Schüttgutprozess. Dies erfordert aber generell mindestens einen zusätzlichen Bearbeitungsschritt.

Um eine Abtrennung der Partikel aus dem Kohlenstoff-Beschichtungsplasma zu erlangen, wurden bisher auch verschiedene Plasma-Filterkonzepte vorgeschlagen, wobei diese in der Regel nicht speziell nur für die Verdampfung von Grafit, sondern auch für metallische Materialien vorgesehen worden sind.

Aus US 2002/007796 A1 ist eine Vorrichtung zur gefilterten Beschichtung durch Bogenentladung bekannt, bei der durch Bogenentladung ein Plasma gebildet und das Plasma durch einen abgeknickten Kanal auf zu beschichtende Substrate gerichtet werden soll. Im Knickbereich ist eine Ablenkungselektrode, die auch aus zwei voneinander getrennten Bereichen gebildet sein kann, angeordnet. Mit zusätzlichen den den Kanal umschließenden Spulen werden im Inneren des Kanals Magnetfelder ausgebildet, durch die das Plasma zu den Substraten geführt ist.

Eine ähnlich aufgebaute Plasmaquelle ist in US 5 840 163 B beschrieben. Auch hier ist ein abgeknickter Plasmakanal vorhanden. Außerdem sind außen am Kanal mehrere Elektromagnete angeordnet, deren Magnetfelder die Plasmaströmung der zu beschichtenden Substraten beeinflussen sollen.

Bei der in US 7 381 311 B beschriebenen Anlage für eine gefilterte Vakuum-Lichtbogen-Beschichtungsquelle soll ebenfalls eine Beeinflussung der Plasmaströmung mit Ringspulen erfolgen. In einer 90°-Anordnung werden dabei mindestens drei Magnetspulen eingesetzt, um das Plasma zu fokussieren, zu führen und am Ausgang zu homogenisieren.

Für den Spezialfall einer Achsrichtung langgestreckten Kathode mit linienförmiger Vakuum-Lichtbogenentladung existieren ebenfalls Vorschläge zur Separation von Partikeln aus dem Plasma.

Bei diesen drei hier o.g. technischen Lösungen ist ein erheblicher Apparativer- und Steueraufwand erforderlich, um die entsprechenden magnetischen und elektromagnetischen Felder in einer erforderlichen Form zu beeinflussen.

In WO 00/13201 A1 wird der Einsatz einer länglichen Absorberelektrode zur Plasmaablenkung vorgeschlagen, mit der ein positiver Einfluss, also eine Verringerung der Anzahl von auf eine sich ausbildende Schicht auftreffende Partikeln erreicht werden soll. Auf diesem Prinzip aufbauend wurde in DE 102 40 337 A1 vorgeschlagen, zusätzlich ein magnetisches oder elektromagnetisches Feld auszubilden. Konkret sollen zwei Permanentmagnete oder elektrische Spulen eingesetzt werden zwischen denen ein von einem Target gebildetes Plasma hindurchgeführt werden soll. Dabei kann der Abstand der Magnete oder Spulen aber nicht beliebig groß gewählt werden, um eine ausreichend große Feldstärke im Plasmavolumen zu gewährleisten. Dies wirkt sich insbesondere bei großen, insbesondere langgestreckten Targets nachteilig aus, die für die Beschichtung von großflächigen Substraten oder einer Vielzahl von zu beschichtenden Substraten aber gewünscht sind. Daher kann eine aus DE 102 40 337 A1 bekannte Vorrichtung nicht ohne weiteres eingesetzt werden und es müssen mehrere Systeme nebeneinander in Reihe angeordnet sein, was für den Betrieb äußerst unvorteilhaft und häufig auch nicht praktikabel ist.

Insbesondere für den Fall der Verwendung länglicher Targets, wie sie beim Laser-Arc-Verfahren üblicherweise eingesetzt werden, schlägt DE 10 2006 009 160 A1 eine spezielle Anordnung von elektrischen und magnetischen Ablenkelementen vor. Hierbei wird eine elektrisch positiv beaufschlagte Absorberelektrode verwendet, also ein stabförmiger Permanentmagnet oder ein stabförmiger Elektromagnet dessen Länge im Wesentlichen einer Erstreckung der Absorberelektrode parallel zur nutzbaren Länge des Targets entspricht. Mit der beschriebenen Anordnung gelingt eine Ablenkung des Plasmas aus der Sichtlinie, die jedoch keine 90°-Ablenkung erreicht, wie sie in den o.g. Schutzrechtsanmeldungen mit Verwendung von Ringspulen beschrieben wird, wodurch der erreichbare Separationseffekt begrenzt ist.

Weitere Vorrichtung zur Abscheidung von Schichten durch eine Plasmabogenentladung werden in US 6 465 793 B1 und EP 1 245 694 A1 offenbart.

Das mechanische Glätten von rauen harten Kohlenstoffschichten ist ein zusätzlicher Aufwand und kann nur bei bestimmten (einfachen) Konturen und bestimmten Werkstoffen eingesetzt werden.

Die Verwendung von Plasmafilter-Lösungsansätzen mittels Ringspulen erlaubt nur die Verwendung kleiner, scheibenförmiger Targets, konzentrisch zu den ringförmigen Magnetfeldführungen und kann daher nicht über die erforderliche Beschichtungshöhe einer herkömmlichen Beschichtungskammer eingesetzt werden.

Insbesondere die vorgeschlagenen Lösungen für länglich ausgedehnte Targets haben den Nachteil, dass damit keine hinreichende (90°-) Ablenkung möglich ist und somit keine effektive Abtrennung der Partikel aus dem Plasma gelingt.

Es ist daher Aufgabe der Erfindung, Möglichkeiten für eine einfache effektive Separation von Makropartikeln aus einem mittels elektrischer Lichtbogenentladung generierten Plasma, das zur Ausbildung harter amorpher Kohlenstoffschichten auf Bauteiloberflächen genutzt wird und dazu ein großformatiges als Kathode geschaltetes, länglich ausgebildetes, zylindrisches Graphittarget eingesetzt wird, anzugeben.

Erfindungsgemäß wird diese Aufgabe mit einer Vorrichtung, die die Merkmale des Anspruchs 1 aufweist, gelöst. Vorteilhafte Aus- und Weiterbildungen können mit in untergeordneten Ansprüchen bezeichneten Merkmalen realisiert werden.

Bei der erfindungsgemäßen Vorrichtung wird ein Plasma unter Vakuumbedingungen mittels einer elektrischen gepulst betriebenen Pulsstromquelle zwischen einem als Kathode geschalteten Target, das zumindest überwiegend aus Grafit besteht und einen zumindest annähernd rechteckigen Querschnitt aufweist, und mindestens einer Anode generiert. Das Plasma ist durch einen Plasmakanal, der in einem Abstand zu der/den Anode(n) und mindestens einem zu beschichtenden Bauteil in einem Winkel zwischen 120° und 60°, bevorzugt um 90° abgewinkelt ist, durch das Innere einer einzigen elektrischen Spule mit rechteckigem Querschnitt zu mindestens einem Bauteil geführt.

Die elektrische Spule ist so an die elektrische Pulsstromquelle angeschlossen, dass ein elektrischer Stromfluss durch die elektrische Spule infolge eines Entladestromes der elektrischen Pulsstromquelle jeweils während eines Pulses einer elektrischen Lichtbogenentladung erfolgt und von der elektrischen Spule ein das Plasma im Plasmakanal umschließendes elektromagnetisches Feld ausgebildet ist.

Dies hat den Vorteil, dass man auf zusätzliche weitere kostenintensive elektrische Stromquellen für Spulen und/oder Elektroden verzichten kann und der Aufwand für eine Steuer- oder Regelung zur Separation von Makropartikeln aus dem Plasmastrom in Richtung einer zu beschichtenden Bauteiloberfläche erheblich reduzieren kann.

Das Target kann bevorzugt als mindestens ein zylinder- oder hohlzylinderförmiger Körper ausgebildet sein. Dabei können mehrere solcher Körper auch in einer Reihenanordnung nacheinander aber möglichst entlang einer gemeinsamen mittleren Längsachse auch mit Abständen zueinander angeordnet sein.

Die elektrische Spule weist maximal zwölf, bevorzugt maximal zehn Windungen und mindestens 5 Windungen auf. Dabei sollte mindestens 1 Windung je 100 mm ausgebildet sein.

Die elektrische Spule sollte so angeschlossen sein, dass die Richtung des elektrischen Stromflusses durch die elektrische Spule infolge eines Entladestromes der elektrischen Pulsstromquelle während eines Pulses einer elektrischen Lichtbogenentladung erfolgt ist, umkehrbar ist. Dabei kann eine solche Umschaltung der Stromflussrichtung alternierend von Puls zu Puls aber auch nach jeweils vorgebbaren Anzahlen von Pulsen periodisch erfolgen. Für die Umschaltung von einer Stromflussrichtung in die entgegengesetzte kann mindestens ein elektrischer Schalter vorhanden sein, mit dem die jeweilige Polung der elektrischen Spule umgekehrt werden kann.

Die elektrische Spule kann in Reihe zwischen der Pulsstromquelle und der Anode oder dem als Kathode geschalteten Target geschaltet werden und die elektrischen Anschlüsse der elektrischen Spule können je nach gewünschter Stromflussrichtung entsprechend beschaltet werden/getauscht werden. Die Stromflussrichtungsumkehr kann mit zwei Schaltern erreicht werden, die jeweils an einem Ende der elektrischen Spule angeordnet sind und beide bei einem Stromrichtungswechsel durch die elektrische Spule gemeinsam umgeschaltet werden.

Mit einer mehrfachen Umkehr der Stromflussrichtung durch die elektrische Spule kann eine Homogenisierung des Plasmas bei dessen Bewegung durch den Plasmakanal und dabei auch über den Querschnitt der Plasmaströmung erreicht werden.

Mit der Pulsstromquelle sollte ein möglichst steiler Anstieg des elektrischen Stromes am Beginn und möglichst auch am Ende eines Pulses als dann negativer Anstieg erreicht werden können. Dies ist mit entsprechend konzipierten Pulsstromquellen möglich.

In Bewegungsrichtung des Plasmas durch den Plasmakanal kann vorteilhaft im Anschluss an den abgewinkelten Bereich, der in Richtung des mindestens einen zu beschichtenden Bauteils weist, eine Reflexionskammer für im Plasma enthaltene Makropartikel angeordnet sein. Mittels der Reflexionskammer kann die kinetische Energie der im Plasma enthaltenen und durch das Magnetfeld der elektrischen Spule unbeeinflussten Makropartikel reduziert und die Bewegungsrichtung der Makropartikel so verändert werden, dass sie nicht in Richtung des Plasmastromes zurück reflektiert werden. Dieser Effekt kann noch verstärkt werden, wenn man einen seitlich zum Plasmakanal ausgebildeten Sammelbereich an der Reflexionskammer vorsieht, der im Schatten des Plasmastromes und der ursprünglichen Bewegungsrichtung von im Plasma mitgeführten Makropartikeln angeordnet ist. Die mit dem Plasma mitgeführten Makropartikel (Droplets) können sich so zuerst mit dem Plasma in der gleichen Richtung mitbewegen. Das Plasma wird infolge der des mittels der elektrischen Spule ausgebildeten Magnetfeldes in den abgewinkelten Bereich des Plasmakanals in Richtung der zu beschichtenden Bauteile umgelenkt. Die Makropartikel werden nicht beeinflusst und bewegen sich gerade aus weiter und treffen in der Reflexionskammer auf eine Wand auf, die in einem Winkel zwischen 0° und 90° in Bezug auf die Bewegungsrichtung des Plasmastromes mit den Makropartikeln ausgerichtet ist. Der Winkel sollte so gewählt sein, dass dort reflektierte Makropartikel in eine Richtung nach dem Aufprall reflektiert werden, bei dem eine Rückreflexion in den Plasmastrom nicht möglich ist. Dazu kann vorteilhaft mindestens eine Reflexion in Richtung Sammelbereich ausgenutzt werden, aus dem keine Rückflexion in Richtung Plasmastrom und Bauteiloberfläche möglich ist.

Die elektrische Spule sollte in ihrem Inneren so dimensioniert und mit ihren Querschnitt gestaltet sein, dass sie mindestens der maximalen äußeren Randkontur des Targets entspricht. Allein oder zusätzlich sollte das Target an seiner längsten Seite eine Ausdehnung von mindestens 300 mm, bevorzugt von mindestens 350 mm aufweisen. Durch eine entsprechende Dimensionierung und Gestaltung der elektrischen Spule kann gesichert werden, dass das gebildete Plasma zumindest nahezu vollständig durch das Innere der elektrischen Spule bis in den und durch den abgewinkelten Bereich des Plasmakanals geführt und vom mit der elektrischen Spule generierten Magnetfeld entsprechend beeinflusst wird, dass Ionen des Plasmas zu den zu beschichtenden Oberflächen gelangen. Der innere Querschnitt der elektrischen Spule sollte jedoch maximal 20 %, bevorzugt maximal 10 % größer als die Gesamt-Querschnittsfläche des Targets zu Beginn des Einsatzes eines neuen vollständigen Targets sein.

Die elektrische Spule sollte entsprechend der Ausdehnung des Targets im Querschnitt länglich ausgeführt werden, wobeidie Längsausdehnung mindestensder Gesamtausdehnungdes Targets, vorzugsweise zwischen 400 mm und 1000 mm liegen sollte.

In der ursprünglichen Bewegungsrichtung des Plasmas kann im Anschluss an den abgewinkelten Bereich, der in Richtung des mindestens einen zu beschichtenden Bauteils weist, ein Permanentmagnet angeordnet sein. Der Permanentmagnet sollte U-förmig ausgebildet sein und seine Schenkel in einem Abstand zueinander angeordnet sein, die mindestens der Breite des Plasmakanals entspricht. Die magnetische Feldstärke des mit dem Permanentmagnet generierten Magnetfeldes sollte mindestens so groß sein, wie die maximale magnetische Feldstärke des mit der elektrischen Spule generierten elektromagnetischen Feldes ist. Damit kann erreicht werden, dass das Magnetfeld des Permanentmagneten den Plasmastrom zusätzlich in den abgewinkelten Bereich umlenken kann und verhindern kann, dass elektrisch geladene Bestandteile, insbesondere Ionen des Plasmas in die Reflexionskammer gelangen können.

Der Entladungsstrom, der nach dem Abschalten einer elektrischen Bogenentladung durch die elektrische Spule fließt sollte eine maximale Stromstärke im Bereich 200 Aund 3500 A, bevorzugt eine maximale Stromstärke im Bereich 800 A bis 3200 A und/oder eine Pulslängezwischen50 µs und 2 msund/oder eine Pulsfrequenz zwischen 1 Hz und 2000 Hz, bevorzugt eine Pulslänge zwischen 100 µs und 1 ms und eine Pulsfrequenz zwischen 50 Hz und 1200 Hz aufweisen.

Der Stromfluss durch die elektrische Spule kann in seiner Stromrichtunggetauschtwerden. Vorzugsweise kann dies periodisch alternierend von Bogenentladungspulszu Bogenentladungspuls erfolgen. Es ist auch möglich die Stromflussrichtung durch die elektrische Spule miteinem übergeordneten Wechselintervall mit Pulspaketen im Bereich zwischen 100 ms und 1s zu wechseln.

Ein Target das im Wesentlichen aus Grafit besteht, kann mit mindestens einem chemischen Element mit einem Anteil von maximal 25 at-%, bevorzugt einem Anteil im Bereich 1 at-% bis 10 at-% dotiert sein. Als Dotierungselemente kann man beispielsweise Fe, B, Mo, Si, Cu, W, Cr einzeln oder in Kombination von mindestens zwei dieser chemischen Elemente einsetzen.

Die elektrische Spule kann durch den Plasmakanal ausgehend von der/den Anode(n) bis zum Ende des Plasmakanals und bis vor der Oberfläche des mindestens einen zu beschichtenden Bauteils mit seinen Windungen gestreckt ausgebildet sein. Sie kann dabei auch den abgewinkelten Bereich, in dem die Richtungsänderung des Plasmastroms zu dem/den zu beschichtenden Bauteilen erfolgt, umgreifen.

Die elektrische Spule kann sowohl innerhalb des Plasmakanals angeordnet sein. Sie kann ihn aber auch an seiner Außenseite umschließen bzw. umgreifen.

Die Vorrichtung kann besonders vorteilhaft bei der Durchführung des bereits erläuterten Laser-Arc-Verfahrens eingesetzt werden, bei dem die Zündung elektrischer Bogenentladungen mittels gepulster Bestrahlung der Targetoberfläche mit einem Laserstrahl initiiert wird.

Mit der Erfindung kann eine sehr wirksame zumindest nahezu vollständige Separation von Makropartikeln durch Verwendung lediglich einer elektrischen Spule, mit der eine erhebliche Veränderung der Richtung eines Plasmastromes ausgehend von seiner Quelle dem auf der Targetoberfläche betriebenen elektrischen Bogenentladungen bis hin zu entsprechend angeordneten Bauteilen in einer oder einer weiteren daran angeschlossenen Vakuumkammer erreicht werden. Gleichzeitig ist es möglich, die gesamte Oberfläche eines zylinderförmigen_ Targets auch bei solchen Targets, die eine größere Längserstreckung in eine Achsrichtung aufweisen, zu nutzen und eine homogene Plasmaverteilung innerhalb des Plasmakanals über seine Länge und seine Querschnittsfläche zu gewährleisten.

Die Plasmaumlenkung erfolgt im Wesentlichen mittels der stromdurchflossenen elektrischen Spule, die mit der Bogenentladungsquelle anoden- oder kathodenseitig in Reihe geschalten sein kann. Die bei der bevorzugt gepulsten elektrischen Bogenentladungen freigesetzten Elektronen können durch die elektrische Spule zur der elektrischen Pulsstromquelle zurückgeführt werden.

Das dadurch von der elektrischen Spule generierte Magnetfeld bewirkt eine Umlenkung der Ionen im Gegensatz zu ungeladenen Teilchen, Droplets und Partikeln, die unbeeinflusst sich geradeaus weiter bewegen, wohingegen die Ionen vom Magnetfeld in ihrer Bewegungsrichtung in den abgewinkelten Bereich und von dort zu beschichtenden Bauteilen geführt werden. Die Induktivität der elektrischen Spule verursacht eine längere Stromanstiegs- und Stromabfallzeit, wodurch sich die Dauer der elektrischen Bogenentladung(en) verlängert. Die Zahl der Spulenwindungen ist daher gering zu halten und beträgt daher maximal 12 Windungen.

Die erfindungsgemäße Ausgestaltung der elektrischen Spule unterscheidet sich grundsätzlich von den bisher beschriebenen Spulen-Ausführungsformen für die Ablenkung von Vakuum-Lichtbogenplasmen dahingehend, dass anstelle von mehreren nur eine einzige Spule verwendet wird, die elektrische Spule nicht kontinuierlich oder geregelt im DC- sondern im gepulsten Modus betrieben wird, zum Betrieb der Spule keine zusätzliche Stromquelle erforderlich ist, sondern der Entladungsstrom der Vakuum-Lichtbogenentladung verwendet wird und die Windungsanzahl der Spule maximal 12, bevorzugt 10 und damit deutlich weniger als bei einer herkömmlichen Ablenkspule beträgt.

Optional können durch den Einsatz eines zweiteiligen Elektronenabsorber-Elementes, das in Reihe zwischen dem Pluspol der Pulsstromquelle und elektrischer Spule geschaltet wird, weitere Elektronen abgezogen werden.

Der Anschluss der einzelnen Elektronenabsorber-Elemente sollte so erfolgen, dass die abfließenden Elektronen ein Magnetfeld ausbilden, das das Plasma bereits vor der elektrischen Spule fokussiert. Die Elektronenabsorber-Elemente können so ausgebildet sein, wie es beispielsweise in WO 00/13201 A1 bzw. DE 102 40 337 A1 beschrieben sind.

Auch die Geometrie der Anode kann so ausgeführt werden, dass einerseits das Maximum an Elektronen abgezogen werden kann und es andererseits zu einer Fokussierwirkung kommt. Die Anode kann dazu kammförmig ausgebildet sein und die Zähne bzw. Zinken dabei in Richtung Targetoberfläche weisen.

Es können auch zusätzlich zu den Anoden Absorberelektroden vorhanden sein, die in einem Abstand zueinander und zum Target angeordnet sind. Die Anoden und Absorberelektroden sollten dabei so angeordnet sein, dass bei der elektrischen Bogenentladung generiertes Plasma zwischen Anoden und zwei Absorberelektroden in den Plasmakanal und von dort zu zu beschichtenden Bauteiloberflächen gelangen kann.

Auch der Einsatz eines Permanentmagneten im Außenradius der elektrischen Spule kann die Umlenkung der Richtung des Plasmastromes vom Plasma positiv beeinflussen. Die Position und Lage des Permanentmagneten hat direkten Einfluss auf die Umlenkung des Plasmas.

Die Position der Spulenwindungen und die Windungsanzahl der elektrischen Spule können variiert werden. Die elektrische Spule kann sowohl innerhalb der Plasmakammer, als auch außerhalb der Außenwand der Plasmakammer positioniert werden.

Es hat sich gezeigt, dass die Stromrichtung der in Reihe geschalteten elektrischen Spule einen Einfluss auf die Position des abgelenkten Plasmas in Längsrichtung hat. Eine Umkehr der Stromrichtung führt daher zu einer Verschiebung des Plasmas am Spulenausgang. Damit kann eine periodische Umschaltung der Stromrichtung der in Reihe zwischen Anode und elektrischer Gleichspannungsstromquelle geschalteten elektrischen Spule eine Vergrößerung des Plasmabereichs und damit des Beschichtungsbereichs bewirken.

Mit der Erfindung gelingt es über einen größeren Beschichtungsbereich diamantähnliche Kohlenstoffschichten aus einem Grafittarget herzustellen, die nahezu keine Defekte durch bei der Vakuum-Bogenverdampfung entstandene Partikel enthalten. Da die Partikel keine Ablenkkräfte erfahren, sondern sich weiter geradlinig ausbreiten, werden sie aus dem zur Beschichtung genutzten Plasma abgetrennt. Die Besonderheit ist die, dass die vorgeschlagene Lösung erstmals ein effektives Plasma-Partikelfilter darstellt, mit dem eine ausreichende, bevorzugt 90°-Ablenkung eines Kohlenstoffplasmas aus einem länglich ausgebildeten Kohlenstoff target möglich ist. Die Ablenkung gestattet eine große räumliche Ausdehnung, das heißt eine längere Flugstrecke der nicht abgelenkten Makropartikel, bevor diese durch eine reflektierende Platte in einen seitlich abgeknickten Bereich der Reflexionskammer geleitet werden und damit auch nach Wandreflexionen in der Reflexionskammer bis hinein in den Sammelbereich an der Reflexionskammer, der im Schatten des Plasmastromes angeordnet ist, nicht mehr zurück in den Plasmabereich gelangen können.

Alle mit verschleißfesten Kohlenstoffschichten versehenen Gleitkomponenten oder Bauteile für Mobilitäts- oder stationäre Maschinenanwendungen, d.h. für Motoren, Antriebssysteme, Pumpen, Führungen, insbesondere Lagerkomponenten, Zahnräder, Kolbenringe, Kolbenbolzen, Ventile, Ventiltriebsbauteile, Zylinder, Kolben, Wellen und Stößel können mit einer erfindungsgemäßen Vorrichtung an ihrer Oberfläche zumindest nahezu defektfrei beschichtet werden. Des Weiteren können alle Arten von reibungs- bzw. verschleißbeanspruchten Werkzeugen zur spanenden oder umformenden Bearbeitung beschichtet werden. Es können auch Schutzschichten bzw. anderweitig funktionale Schichten auf Komponenten, Bauteilen, Folien etc. als Kratzschutz, Korrosionsschutz, Diffusionsbarriere oder für dekorative Zwecke ausgebildet werden.

Nachfolgend soll die Erfindung beispielhaft näher erläutert werden.

Dabei zeigen:
Figur 1 in schematischer Form ein erstes Beispiel einer erfindungsgemäßen Vorrichtung;
Figur 2 in schematischer Form ein zweites Beispiel einer erfindungsgemäßen Vorrichtung;
Figur 3 in schematischer Form ein drittes Beispiel einer erfindungsgemäßen Vorrichtung;
Figur 4 ein Beispiel für einen elektrischen Anschluss einer elektrischen Spule, die bei einer erfindungsgemäßen Vorrichtung anodenseitig eingesetzt ist und
Figur 5 ein Beispiel für einen elektrischen Anschluss einer elektrischen Spule, die bei einer erfindungsgemäßen Vorrichtung kathodenseitig eingesetzt ist.

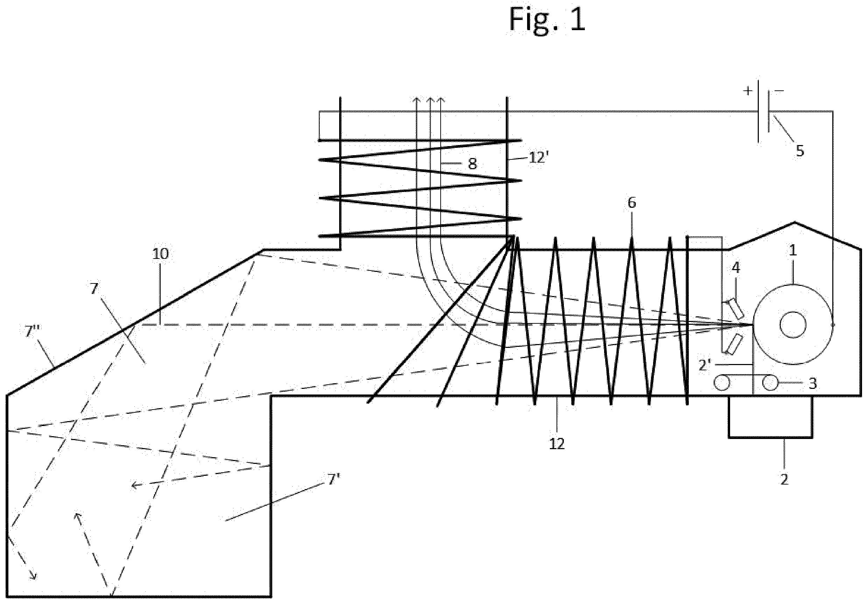

In Figur 1 ist ein erstes Beispiel einer erfindungsgemäßen Vorrichtung gezeigt. Dabei ist an einem Ende einer Plasmakammer 12 ein zylinderförmiges Target 1, das im Wesentlichen aus Grafit besteht, und in die Zeichnungsebene hinein eine Längenausdehnung von mindestens 300 mm, bei einem Außendurchmesser im Ausgangszustand der kleiner als 300 mm ist, aufweist, angeordnet. Das Target 1 kann um seine Längsachse rotieren.

Zur Zündung von elektrischen Bogenentladungen wird ein Laserstrahl 2' von einer Laserquelle 2 durch ein Fenster in den Plasmakanal 12 auf die Targetoberfläche an wechselnden Positionen gerichtet wird. Dabei wird mit einer Vorrichtung 3 eine Schutzfolie eingesetzt, mit der eine Verschmutzung des Fensters verhindert werden kann. Das Target 1 ist kathodenseitig mit der elektrischen Pulsstromquelle 5 verbunden und bei diesem Beispiel sind zwei Anoden 4 über die elektrische Spule 6 mit dem Pluspol der Pulsstromquelle 5 verbunden. Target 1 und Anoden 4 sind in einem Abstand angeordnet, bei dem eine Zündung elektrischer Bogenentladungen bei der anliegenden elektrischen Spannung und des elektrischen Stromes der fließt, wenn eine elektrische Bogenentladung erfolgt, realisierbar ist.

Der Plasmakanal 12 ist über eine Strecke geradeaus ausgerichtet. Nach einer geraden Strecke mit einer Länge von mindestens 100 mm ist ein abgewinkelter Bereich 12' vorhanden, der bei diesem Beispiel mit einem Winkel von 90° in Richtung eines Bereichs des Plasmakanals 12 in dem Bauteile zum Beschichten angeordnet sind oder in eine nicht gezeigte angeflanschte Beschichtungskammer abzweigt.

Bei dem in Figur 1 gezeigten Beispiel ist die elektrische Spule 6 außen um den Plasmakanal 12 gewickelt und hat einen inneren Querschnitt, der größer als die Querschnittsfläche eines unverbrauchten Targets 1 ist. Die elektrische Spule 6 ist bei diesem Beispiel im Strom des Plasmas 8 im Nachgang zu den Anoden 4 bis in den abgewinkelten Bereich 12' und dort bis nahezu zu den zu beschichtenden Bauteilen geführt. Sie ist außerdem elektrisch mit einer Anode 4 und dem positiven Pol der elektrischen Pulsstromquelle 5 verbunden. Sie überdeckt dabei auch den abgewinkelten Bereich 12' des Plasmakanals 12.

Im Anschluss an den abgewinkelten Bereich 12' des Plasmakanals 12 ist ein geradliniger Bereich vorhanden, der eine Reflexionskammer 7 bildet, die eine Wand 7" hat, die in einem Winkel größer 0° und kleiner 90° in Bezug zur Längsachse des geraden Bereich des Plasmakanals 12 ausgerichtet ist. Der Winkel in dem diese Wand 7" in Bezug zur mittleren Längsachse des Plasmakanals 12 ausgerichtet ist, ist so gewählt, dass elektrisch neutrale Makropartikel 10 nicht in Richtung Plasma 8 und in Richtung Target 1 zurück reflektiert, sondern in eine andere Richtung umgelenkt werden. Bei dem gezeigten Beispiel ist an der Reflexionskammer 7 auch eine Sammelkammer 7' vorhanden, die im Schatten des Stromes des Plasmas 8 angeordnet ist, so dass elektrisch neutrale Makropartikel 10 dort gefangen werden können.

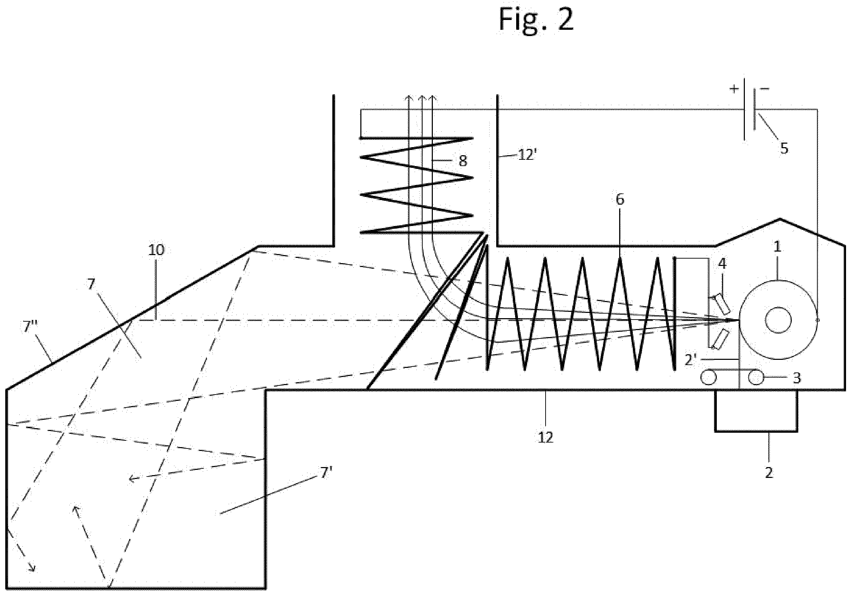

Das in Figur 2 gezeigte zweite Beispiel unterscheidet sich vom ersten Beispiel nach Figur 1 lediglich dadurch, dass die elektrische Spule 6 innerhalb des Plasmakanals 12 angeordnet ist.

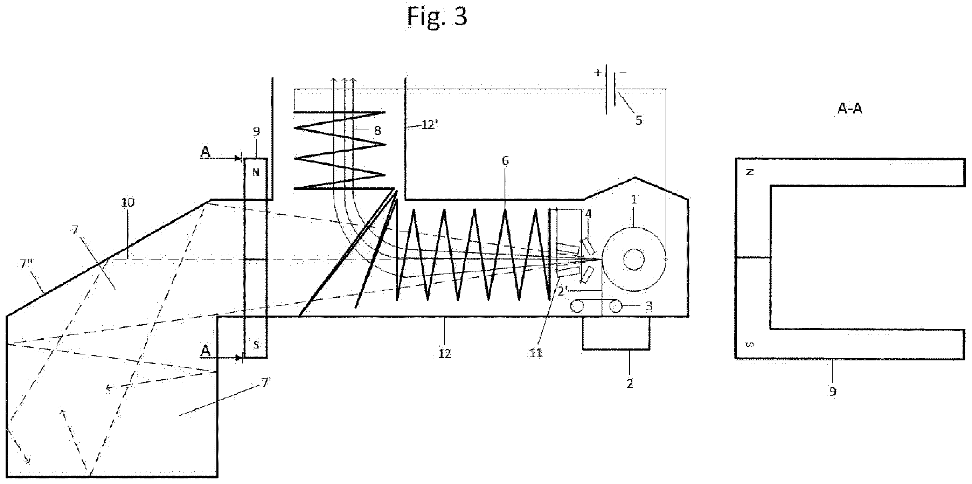

Das in Figur 3 gezeigte dritte Beispiel unterscheidet sich vom in Figur 2 gezeigten zweiten Beispiel, dadurch dass ein U-förmiger Permanentmagnet 9 im Anschluss an den abgewinkelten Bereich 12' den Plasmakanal 12 mit seinen Schenkeln umgreifend angeordnet ist. Das mit dem Permanentmagneten 9 ausgebildete Magnetfeld führt dazu, dass elektrisch geladene Bestandteile des Plasmas 8 blockiert und zusätzlich zu der Magnetfeldwirkung der elektrischen Spule 6 in den abgewinkelten Bereich 12' umgelenkt werden. Der Permanentmagnet 9 ist in der rechten Darstellung von Figur 3 als separates Element gesondert in einer anderen Ansicht gezeigt.

Außerdem sind bei diesem Beispiel neben dem mit den Anoden 4 beeinflussten, bevorzugt fokussierten Plasmastrom in dessen Strömungsrichtung nach dem Anoden 4 Absorberelektroden 11 angeordnet sind, mit denen Elektronen zusätzlich aus dem Plasma 8 separiert werden, mit der Wirkung der damit generierten magnetischen Felder erfolgt ein zusätzlicher Einfluss auf das Plasma 8.

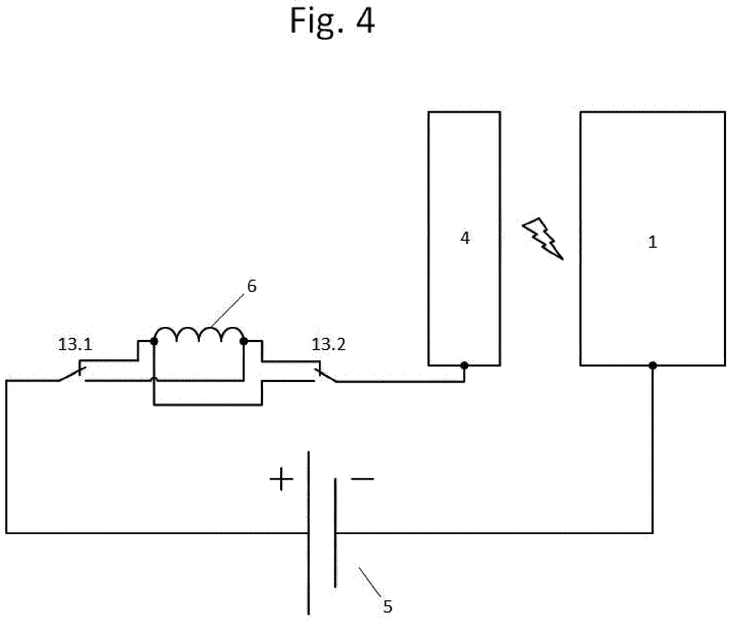

Figur 4 zeigt eine elektrische Schaltung, wie die elektrische Spule 6 anodenseitig angeschlossen werden kann.

Dabei ist der Minuspol der Pulsstromquelle 5 direkt an das Target 1, als Kathode angeschlossen. Die elektrische Spule 6 ist mit dem anderen Pol der Pulsstromquelle 5 über einen Schalter 13.1 verbunden. Das andere Ende der elektrischen Spule 6 ist mit dem Schalter 13.2 mit der Anode 4 verbunden, wenn die beiden Schalter 13.1 und 13.2 wie in Figur 4 gezeigt geschaltet worden sind. Der elektrische Strom fließt somit vom Pluspol der Pulsstromquelle 5 über die elektrische Spule 6 zur Anode 4.

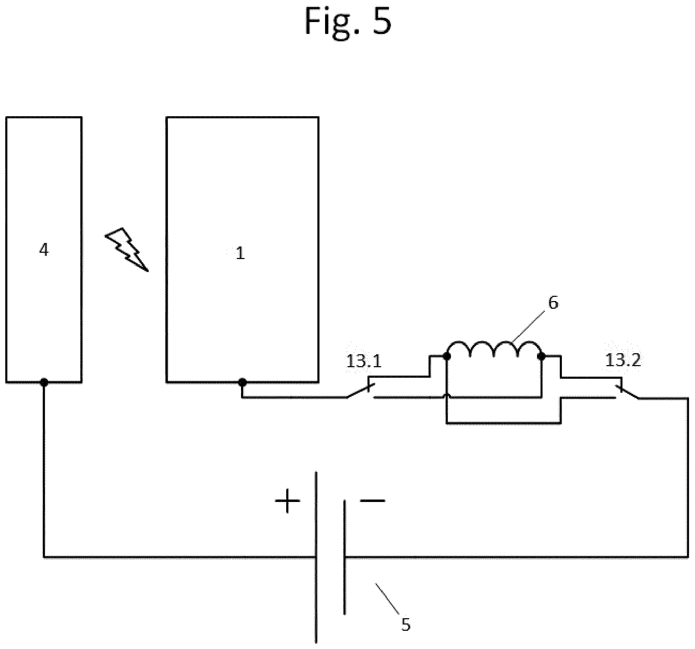

Bei der in Figur 5 gezeigten Variante ist die Spule, kathodenseitig in Reihe geschaltet. Die Richtung des elektrischen Stromflusses kann geändert werden indem die elektrischen Schalter 13.1 und 13.2 beide geschaltet werden, so dass der elektrische Strom vom Target 1 über die elektrische Spule 6 zum Minuspol der Pulsstromquelle 5 fließt.

## Patentansprüche

1. Vorrichtung zur Ausbildung von amorphen Kohlenstoffschichten auf-Bauteiloberflächen mit reduzierter Oberflächenrauheit, bei der ein Plasma (8) unter Vakuumbedingungen mittels einer elektrischen Pulsstromquelle (5) zwischen einem als Kathode geschalteten Target (1), das zumindest überwiegend aus Grafit besteht, und mindestens einer Anode (4) generiert und
Plasma (8) durch einen Plasmakanal (12), der in einem Abstand zu der/den Anode(n) (4) und mindestens einem zu beschichtenden Bauteil einen Bereich (12') in einem Winkel zwischen 120° und 60° abgewinkelt ist, durch das Innere einer einzigen elektrischen Spule (6) zu mindestens einem Bauteil geführt ist, und
die elektrische Spule (6) so an die elektrische Pulsstromquelle (5) angeschlossen ist, dass ein elektrischer Stromfluss durch die elektrische Spule (6) infolge eines Entladestromes der elektrischen Pulsstromquelle (5) zur Generierung von Pulsen elektrischer Lichtbogenentladungen erfolgt und von der elektrischen Spule (6) ein das Plasma (8) im Plasmakanal (12) umschließendes elektromagnetisches Feld ausgebildet ist,
**dadurch gekennzeichnet, dass** das Target (1) einen zumindest annähernd rechteckigen Querschnitt aufweist und die elektrischen Spule (6) einen rechteckigen Querschnitt, und dass die elektrische Spule (6) maximal zwölf Windungen aufweist.

2. Vorrichtung nach Anspruch 1, wobei die elektrische Spule (6) maximal zehn Windungen aufweist.

3. Vorrichtung nach einem der vorhergehenden Ansprüche, wobei die elektrische Spule (6) so an die elektrische Pulsstromquelle (5) angeschlossen ist, dass die Richtung des elektrischen Stromflusses durch die elektrische Spule (6) umkehrbar ist.

4. Vorrichtung nach dem vorhergehenden Anspruch 1, wobei die elektrische Spule (6) in Reihe zwischen der Pulsstromquelle (5) und der Anode (4) oder dem als Kathode geschalteten Target (1) geschaltet ist.

5. Vorrichtung nach einem der vorhergehenden Ansprüche, wobei sich in Bewegungsrichtung des Plasmas (8) im Anschluss an den abgewinkelten Bereich (12'), der in Richtung des mindestens einen zu beschichtenden Bauteils weist, eine Reflexionskammer (7) für im Plasma (8) enthaltene Makropartikel (10) angeordnet ist.

6. Vorrichtung nach einem der vorhergehenden Ansprüche, wobei sich in Bewegungsrichtung des Plasmas (8) im Anschluss an den abgewinkelten Bereich (12'), der in Richtung des mindestens einen zu beschichtenden Bauteils weist, ein Permanentmagnet (9) angeordnet ist.

7. Vorrichtung nach einem der vorhergehenden Ansprüche, wobei die elektrische Spule (6) in ihrem Inneren so dimensioniert und mit ihrem Querschnitt gestaltet ist, dass sie mindestens der maximalen äußeren Randkontur des Targets (1) entspricht und/oder das Target (1) an seiner längsten Seite eine Ausdehnung von mindestens 300 mm, bevorzugt von mindestens 350 mm aufweist.

8. Vorrichtung nach Anspruch 5, wobei **die Refle**xionskammer (7) einen seitlich zum Plasmakanal (12) ausgebildeten Sammelbereich (7') für dorthin reflektierte Makropartikel (10) aufweist.

9. Vorrichtung nach Anspruch 6, wobei der Permanentmagnet (9) U-förmig ausgebildet ist und seine Schenkel in einem Abstand zueinander angeordnet sind, die mindestens der Breite des Plasmakanals (12) entspricht und/oder die magnetische Feldstärke des mit dem Permanentmagnet generierten Magnetfeldes mindestens so groß ist, wie die maximale magnetische Feldstärke des mit der elektrischen Spule (6) generierten elektromagnetischen Feldes ist.

10. Vorrichtung nach einem der vorhergehenden Ansprüche, wobei ein Entladungsstrom eine maximale Stromstärke im Bereich 200 A und 3500 A, bevorzugt eine maximale Stromstärke im Bereich 800 A bis 3200 A und/oder eine Pulslängezwischen50 µs und 2 ms und/oder eine Pulsfrequenz zwischen1 Hz und 2000 Hz, bevorzugt eine Pulslänge zwischen 100 µs und 1 ms und eine Pulsfrequenz zwischen 50 Hz und 1200 Hz aufweist.

11. Vorrichtung nach einem der vorhergehenden Ansprüche, wobei das Target (1) mit mindestens einem chemischen Element mit einem Anteil von maximal 25 at-%, bevorzugt einem Anteil im Bereich 1 at-% bis 10 at-% dotiert ist.

12. Vorrichtung nach einem der vorhergehenden Ansprüche, wobei die elektrische Spule (6) durch den Plasmakanal (12) ausgehend von der/den Anode(n) (4) bis zum Ende des Plasmakanals (12') und bis vor der Oberfläche des mindestens einen zu beschichtenden Bauteils ausgebildet ist.

13. Vorrichtung nach einem der vorhergehenden Ansprüche, wobei zur gepulsten Zündung von elektrischen Lichtbogenentladungen ein Laserstrahl (2') auf die Oberfläche des Targets (1) mit wechselnden Auftreffpositionen gerichtet ist.

14. Vorrichtung nach einem der vorhergehenden Ansprüche, wobei die Richtung des elektrischen Stromflusses durch die elektrische Spule (6) alternierend oder mit vorgebbarer Periodizität umkehrbar ist.

15. Vorrichtung nach einem der vorhergehenden Ansprüche, wobei zusätzlich zu den Anoden (4) Absorberelektroden (11) vorhanden sind, die in einem Abstand zueinander und zum Target (1) so angeordnet sind, dass der Plasmastrom zwischen den zwei Anoden (4) und den zwei Absorberelektroden (11) durch den Plasmakanal (12) strömt.

## Claims

1. A device for forming amorphous carbon layers on component surfaces with reduced surface roughness, in which a plasma (8) is generated under vacuum conditions using a pulsed electrical current source (5) between a target (1) connected as a cathode and consisting at least primarily of graphite and at least one anode (4), and
plasma (8) is guided through a plasma channel (12), which is at a distance from the anode(s) 4 and at least one component for coating in a region (12') at an angle of between 120° and 60°, through the interior of a single electrical coil (6) to at least one component, and
the electrical coil (6) is connected to the electrical pulsed current source (5) such that an electric current flows through the electrical coil (6) caused by a discharge current from the electrical current source (5) to generate pulses of electrical arc discharges, and the electrical coil (6) generates an electromagnetic field that encloses the plasma (8) in the plasma channel (12),
**characterised in that** the target (1) has an at least approximately rectangular cross-section and the electrical coil (6) has a rectangular cross-section, and **in that** the electrical coil (6) has no more than twelve windings.

2. A device according to claim 1, wherein the electric coil (6) has no more than ten windings.

3. A device according to any one of the preceding claims, wherein the electrical coil (6) is connected to the electrical current source (5) such that the direction in which the electrical current flows through the electrical coil (6) is reversible.

4. A device according to claim 1 above, wherein the electrical coil (6) is connected in series between the pulsed current source (5) and the anode (4) or the target (1) connected as a cathode.

5. A device according to any one of the preceding claims, wherein, in the direction of movement of the plasma (8), a reflection chamber (7) for macroparticles (10) contained in the plasma (8) is arranged immediately after the angled area (12'), which faces the direction of the at least one component for coating.

6. A device according to any one of the preceding claims, wherein there is a permanent magnet (9) arranged in the direction of movement of the plasma (8) immediately after the angled area (12') in the direction of the at least one component for coating.

7. A device according to any one of the preceding claims, wherein the electrical coil (6) is dimensioned internally and designed with a cross-section such that it corresponds at least to the maximum outer edge contour of the target (1) and/or the target (1) has a length of at least 300 mm, preferably at least 350 mm, along its longest side.

8. A device according to claim 5, wherein the reflection chamber (7) includes a collection area (7') formed laterally to the plasma channel (12) for macroparticles (10) reflected at it.

9. A device according to claim 6, wherein the permanent magnet (9) is U-shaped and its legs are spaced apart at a distance corresponding to at least the width of the plasma channel (12), and/or the magnetic field strength of the magnetic field generated by the permanent magnet is at least as great as the maximum magnetic field strength of the electromagnetic field generated by the electrical coil (6).

10. A device according to any one of the preceding claims, wherein a discharge current has a maximum current ranging from 200 A to 3,500 A, preferably a current ranging from no more than 800 A to 3,200 A, and/or a pulse width between 50 µs and 2 ms and/or has a pulse frequency between 1 Hz and 2000 Hz, preferably a pulse width between 100 µs and 1 ms, and a pulse frequency between 50 Hz and 1200 Hz.

11. A device according to any one of the preceding claims, wherein the target (1) is doped with at least one chemical element in a proportion of no more than 25 at%, preferably a proportion ranging from 1 at% to 10 at%.

12. A device according to any one of the preceding claims, wherein the electrical coil (6) extends through the plasma channel (12), starting from the anode(s) (4) and ending with the plasma channel (12') and formed to a point before the surface of the at least one component for coating.

13. A device according to any one of the preceding claims, wherein a laser beam (2') is directed at the surface of the target (1) at varying impact positions to trigger pulsed ignition of electrical arc discharges.

14. A device according to any one of the preceding claims, wherein the direction of the electric current flowing through the electric coil (6) is alternating or reversible at a preset periodicity.

15. A device according to any one of the preceding claims, wherein, in addition to the anodes (4), absorber electrodes (11) are provided, which are arranged at a distance from one another and from the target (1) such that the plasma flow between the two anodes (4) and the two absorber electrodes (11) flows through the plasma channel (12).

## Revendications

1. Dispositif permettant de réaliser des couches de carbone amorphe sur des surfaces de composants avec une rugosité de surface réduite, dans lequel un plasma (8) étant généré sous vide au moyen d'une source de courant électrique pulsé (5) entre une cible (1), connectée en tant que cathode et constituée au moins principalement de graphite, et au moins une anode (4), et
du plasma (8) étant guidé jusqu'à au moins un composant à travers l'intérieur d'une unique bobine électrique (6) grâce à un canal de plasma (12) qui, à une certaine distance de l'anode (4) et d'au moins un composant à revêtir, est coudé dans une région (12') selon un angle compris entre 120° et 60°, et
la bobine électrique (6) est raccordée à la source de courant électrique pulsé (5) de sorte qu'un flux de courant électrique apparait à travers la bobine électrique (6) en raison d'un courant de décharge de la source de courant électrique pulsé (5) afin de générer des impulsions électriques de décharges d'arc et un champ électromagnétique enfermant le plasma (8) dans le canal de plasma (12) est créé par la bobine électrique (6),
**caractérisé en ce que** la cible (1) présente une section transversale au moins approximativement rectangulaire et la bobine électrique (6) présente une section transversale rectangulaire, et **en ce que** la bobine électrique (6) présente un maximum de douze spires.

2. Dispositif selon la revendication 1, dans lequel la bobine électrique (6) présente un maximum de dix spires.

3. Dispositif selon l'une quelconque des revendications précédentes, dans lequel la bobine électrique (6) est raccordée à la source de courant électrique pulsé (5) de sorte que le sens du flux de courant électrique à travers la bobine électrique (6) est réversible.

4. Dispositif selon la revendication 1 précédente, dans lequel la bobine électrique (6) est connectée en série entre la source de courant électrique pulsé (5) et l'anode (4) ou la cible (1) connectée en tant que cathode.

5. Dispositif selon l'une quelconque des revendications précédentes, dans lequel une chambre de réflexion (7) destinée aux macroparticules (10) contenues dans le plasma (8) est agencée dans le sens de déplacement du plasma (8) à la suite de la région coudée (12') qui regarde en direction du au moins un composant à revêtir.

6. Dispositif selon l'une quelconque des revendications précédentes, dans lequel un aimant permanent (9) est agencé dans le sens de déplacement du plasma (8) à la suite de la région coudée (12') qui regarde en direction du au moins un composant à revêtir.

7. Dispositif selon l'une quelconque des revendications précédentes, dans lequel la bobine électrique (6) présente un intérieur qui est dimensionné, et une section transversale qui est conçue, de manière à correspondre à au moins le contour extérieur maximal de la cible (1) et/ou de manière à ce que la cible (1) présente une extension d'au moins 300 mm, de manière préférée d'au moins 350 mm, au niveau de son côté le plus long.

8. Dispositif selon la revendication 5, dans lequel la chambre de réflexion (7) présente une région de collecte (7') formée latéralement par rapport au canal de plasma (12) et destinée aux macroparticules (10) qui y sont réfléchies.

9. Dispositif selon la revendication 6, dans lequel l'aimant permanent (9) est réalisé en forme de U et ses branches sont agencées à une distance l'une de l'autre qui correspond à au moins la largeur du canal de plasma (12) et/ou l'intensité de champ magnétique du champ magnétique généré par l'aimant permanent est au moins aussi grande que l'intensité de champ magnétique maximale du champ électromagnétique généré par la bobine électrique (6).

10. Dispositif selon l'une quelconque des revendications précédentes, dans lequel un courant de décharge présente une intensité maximale située dans la plage comprise entre 200 A et 3500 A, de manière préférée une intensité maximale située dans la plage comprise entre 800 A et 3200 A et/ou une durée d'impulsion située dans la plage comprise entre 50 µs et 2 ms et/ou une fréquence d'impulsion située dans la plage comprise entre 1 Hz et 2000 Hz, de manière préférée une durée d'impulsion située dans la plage comprise entre 100 µs et 1 ms et une fréquence d'impulsion située dans la plage comprise entre 50 Hz et 1200 Hz.

11. Dispositif selon l'une quelconque des revendications précédentes, dans lequel la cible (1) est dopée avec au moins un élément chimique dans une proportion d'au plus 25 % at., de manière préférée dans une proportion située dans la plage comprise entre 1 % at. et 10 % at.

12. Dispositif selon l'une quelconque des revendications précédentes, dans lequel la bobine électrique (6) est réalisée à travers le canal de plasma (12) à partir de la ou des anode(s) (4) jusqu'à l'extrémité du canal de plasma (12') et jusqu'au devant de la surface du au moins un composant à revêtir.

13. Dispositif selon l'une quelconque des revendications précédentes, dans lequel un faisceau laser (2') est dirigé vers la surface de la cible (1) avec des positions d'impact changeantes en vue de l'allumage pulsé de décharges d'arc électriques.

14. Dispositif selon l'une quelconque des revendications précédentes, dans lequel le sens du flux de courant électrique traversant la bobine électrique (6) peut être inversé de manière alternée ou avec une périodicité prédéfinie.

15. Dispositif selon l'une quelconque des revendications précédentes, dans lequel des électrodes d'absorption (11) sont fournies en plus des anodes (4), lesdites électrodes d'absorption étant agencées à distance l'une de l'autre et à distance de la cible (1) de sorte que le courant de plasma circule à travers le canal de plasma (12) entre les deux anodes (4) et les deux électrodes d'absorption (11).
